# FASCICULE DE BREVET EUROPEEN

(11) **EP 3 940 112 B1**
(45) Date de publication et mention de la délivrance du brevet: **06.08.2025**
(21) Numéro de dépôt: 21181216.9
(22) Date de dépôt: 23.06.2021
(51) Int. Cl.: C23C 14/48, C23C 14/06, C23C 14/58, C23C 30/00, G04B 1/04, G04B 13/02, G04B 15/14, G04D 3/00

(54) **PROCEDE D AMELIORATION D'UN MATERIAU DE PIECE HORLOGERE**
VERFAHREN ZU VERBESSERUNG EINES MATERIALS FÜR UHRWERKE
METHOD FOR IMPROVING A MATERIAL FOR TIMEPIECE

(30) Priorité: 16.07.2020 CH 883202020
(43) Date de publication de la demande: 19.01.2022
(60) Demande divisionnaire: 25158768.9
(73) Titulaire: RICHEMONT INTERNATIONAL SA, 1752 Villars-sur-Glâne (CH)
(72) Inventeur: GUERIN-DELETANG, Sandrine, Morteau (FR); ROLLAND, Julian, Prévessin-Moens (FR); GOUIDER, Mohamed, Neuchâtel (CH); OULEVEY, Frédéric, Saint-George (CH); SERPRY, Anthony, Aubonne (CH); DIABY, Moussa, Fontenay le Fleury (FR)
(74) Mandataire: LLR

(56) Documents cités:
- EP-A1- 2 757 423
- EP-A1- 3 285 123
- JP-A- H1 175 918
- VOLZ K. ET AL: "Nitrogen plasma immersion ion implantation and siliconsputter deposition combined with methane implantation as an in-line process for improving corrosion and wearperformance of stainless steels", SURFACE AND COATINGS TECHNOLOGY, vol. 128-129, 1 June 2000 (2000-06-01), pages 479 - 483, XP055857407
- AL-TAMIMI Z ET AL: "Metallic glass formation by ion implantation into nickel", VACUUM, PERGAMON PRESS, GB, vol. 34, no. 10-11, 1 October 1984 (1984-10-01), pages 861 - 865, XP025721456, ISSN: 0042-207X, [retrieved on 19841001], DOI: 10.1016/0042-207X(84)90164-7
- HOHMUTH K ET AL: "Formation of glassy films by ion implantation into metals", JOURNAL OF NON-CRYSTALLINE SOLIDS, NORTH-HOLLAND PHYSICS PUBLISHING. AMSTERDAM, NL, vol. 56, no. 1-3, 1 July 1983 (1983-07-01), pages 381 - 384, XP024064464, ISSN: 0022-3093, [retrieved on 19830701], DOI: 10.1016/0022-3093(83)90498-2

## Description

### DOMAINE TECHNIQUE DE L'INVENTION

La présente invention se rapporte à un procédé destiné à améliorer les caractéristiques mécaniques, telles que la résistance à l'usure et/ou les caractéristiques tribologiques, d'une pièce horlogère.

### ARRIÈRE-PLAN TECHNIQUE DE L'INVENTION

La proximité au quotidien d'aimants et d'appareillages générant des champs magnétiques peut dérégler de manière non négligeable la marche d'une pièce d'horlogerie telle qu'une montre. Il est alors intéressant de trouver des solutions permettant de limiter la sensibilité magnétique des mouvements de montre, et en particulier en faisant appel à des matériaux de faible susceptibilité magnétique.

Toutefois, la faible susceptibilité magnétique d'un matériau est généralement antagoniste de bonnes caractéristiques mécaniques et tribologiques. Il a déjà été proposé, dans les documents EP 2 757 423 et EP 3 273 303, de durcir superficiellement des matériaux à faible susceptibilité magnétique à l'aide d'une cémentation, d'une nitruration ou d'une boruration. Le but de ces documents est d'intégrer des atomes de carbone, d'azote ou de bore dans des sites interstitiels ou substitutionnels d'un matériau à faible susceptibilité magnétique.

Bien que la dureté de la surface externe soit effectivement augmentée à l'aide des procédés de ces documents, il a toutefois été remarqué lors d'essais qu'une telle intégration interstitielle donnait satisfaction pendant une durée assez courte et que le coefficient de frottement et, incidemment, la résistance à l'usure plongeait à court terme entraînant, à long terme, une détérioration plus rapide que par le matériau sans intégration interstitielle.

### RÉSUMÉ DE L'INVENTION

L'invention a pour but de proposer un nouveau procédé permettant d'améliorer, de manière durable, les propriétés tribologiques comme, notamment, la résistance à l'usure et/ou les propriétés mécaniques d'une pièce horlogère à base d'un matériau sans dégrader sa résistance à la corrosion.

À cet effet, l'invention se rapporte à un procédé de fabrication d'une pièce horlogère comportant une étape a destinée à former une pièce horlogère à base d'un matériau métallique amagnétique et une étape b destinée à réaliser au moins une implantation ionique d'atomes d'au moins deux types différents d'éléments chimiques, un premier élément chimique étant choisi parmi du carbone, de l'azote, de l'oxygène et du bore et un deuxième élément chimique, différent du premier élément chimique, étant choisi parmi le silicium et le bore, pour former des composés chimiques de ces deux différents éléments chimiques dans le réseau cristallin du matériau de la pièce horlogère afin d'améliorer les propriétés tribologiques comme, notamment, la résistance à l'usure et/ou les caractéristiques mécaniques de la pièce horlogère sans dégrader la résistance à la corrosion du matériau de la pièce horlogère.

Avantageusement selon l'invention, le procédé n'intègre pas des éléments chimiques uniques de manière interstitielle ou substitutionnelle comme dans les documents EP 2 757 423 et EP 3 273 303 mais des composés chimiques qui sont beaucoup plus stables dans le réseau cristallin du matériau de la pièce horlogère, c'est-à-dire qui notamment sont plus difficiles à se combiner à des éléments chimiques déjà présents dans le matériau de la pièce horlogère comme du chrome et qui ont une possibilité de migration très limitée dans ou entre chaque maille du réseau cristallin.

Typiquement, il peut être avantageusement obtenu des borures et/ou des carbures et/ou des nitrures ou, plus généralement des composites métal - céramiques associés à des éléments comme le bore, l'azote et le carbone, formant une modification du réseau cristallin du matériau de la pièce horlogère, c'est-à-dire une interruption de la périodicité du cristal pour un matériau cristallin de la pièce horlogère ou un changement surfacique et/ou volumique pour un matériau amorphe de la pièce horlogère. Bien entendu, en cas de matériau semi-cristallin, c'est-à-dire comportant des parties cristallines et amorphes mélangées, ces effets peuvent être combinés.

De fait, il a été observé une résistance à l'usure et un coefficient de frottement de la pièce horlogère améliorés de manière durable, c'est-à-dire aussi bien à court terme qu'à long terme, par rapport à une pièce formée uniquement à partir de l'étape a. En outre, la résistance à la corrosion du matériau de la pièce horlogère n'est pas dégradée, voire, suivant le matériau de la pièce horlogère utilisé, comme à base de cuivre, est améliorée. Enfin, l'étape b peut avantageusement être utilisée en outre pour modifier la couleur de la pièce horlogère.

La pièce ainsi fabriquée peut par conséquent avantageusement former tout ou partie d'un habillage horloger ou d'un mouvement horloger. L'invention s'est révélée utile pour la fabrication d'arbres horlogers comme un pivot, une bonde de barillet ou une tige de remontoir, d'engrenages comme une roue dentée ou un pignon et diverses pièces utilisées en frottement telles qu'un sautoir, un cliquet, un tambour de barillet ou une lame ressort de barillet.

L'invention peut également comporter l'une ou plusieurs des caractéristiques optionnelles suivantes, prises seules ou en combinaison.

Afin de préparer la pièce horlogère pour l'étape b, l'étape a peut, selon une première variante, comporter une fabrication additive. Selon une deuxième variante, l'étape a peut comporter une première sous-étape de fabrication du matériau sous forme d'ébauche et une deuxième sous-étape de mise en forme de l'ébauche.

Le matériau métallique amagnétique peut être un matériau à base de cuivre (pur ou en alliage), à base de nickel (pur ou en alliage), à base d'or (pur ou en alliage), à base d'alliage argent-palladium (alliage binaire pur ou comportant plus d'élément(s) d'alliage), à base de cobalt (pur ou en alliage), à base de chrome(pur ou en alliage), à base de tungstène(pur ou en alliage), à base de fer amagnétique (pur ou en alliage), à base de titane (pur ou en alliage) ou à base d'acier inoxydable du type austénitique comme du type 316L. Bien entendu, d'autres types de matériaux et notamment d'autres matériaux métalliques amagnétiques peuvent être envisagés sans sortir du cadre de l'invention.

Selon une alternative, l'étape b peut comporter une sous-étape d'implantation ionique pour plusieurs types différents d'éléments chimiques en même temps ou plusieurs sous-étapes d'implantation ionique, chaque implantation ionique étant mise en œuvre pour un unique type d'élément chimique en même temps. À titre d'exemple, la première partie de l'alternative permet de limiter le nombre de sous-étapes alors que la deuxième partie de l'alternative permet de faire appel à différentes techniques d'implantation ionique comme, par exemple, l'implantation par faisceau d'ions (en anglais « beamline ion implantation ») et l'implantation par immersion plasma (en anglais « plasma immersion ion implantation » ou « PIII ») permettant notamment d'obtenir un plus grand nombre de composés chimiques.

Selon une autre alternative, l'étape b peut être réalisée à chaud ou, après l'étape b, une étape c de traitement thermique est réalisée afin de faciliter la formation des composés chimiques. Typiquement, l'étape b est préférentiellement réalisée à une température comprise entre 300 °C et 500 °C ou l'étape c est préférentiellement réalisée à une température comprise entre 300 °C et 500 °C pendant une durée comprise entre 1 heure et 24 heures. L'apport de chaleur est privilégié pour améliorer la combinaison entre eux des éléments chimiques intégrés par implantation ionique et pour implanter ces derniers plus profondément dans la pièce horlogère.
Le procédé selon l'invention peut comporter, avant l'étape b et/ou après l'étape b, une étape d de finition destinée à modifier l'état de surface de la pièce horlogère. Typiquement, l'étape d peut comporter une sous-étape de polissage et/ou une sous-étape de roulage et/ou une sous-étape de décoration. À titre d'exemple, une sous-étape de polissage après l'étape b peut être rendue nécessaire si la surface extérieure de la pièce horlogère avant l'implantation ionique des éléments chimiques est très rugueuse, une étape de roulage peut améliorer la dureté et la précision géométrique de la pièce horlogère et une étape de décoration peut améliorer l'esthétique de la pièce horlogère.

### BRÈVE DESCRIPTION DES DESSINS

D'autres particularités et avantages de l'invention ressortiront clairement de la description qui en est faite ci-après, à titre indicatif et nullement limitatif, en référence aux dessins annexés, dans lesquels :

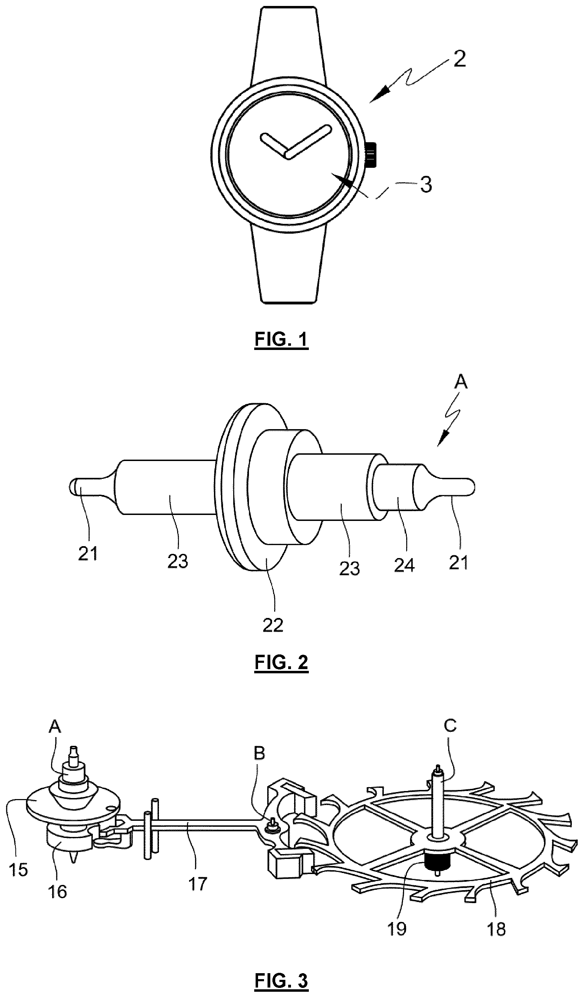

- La figure 1 est une vue schématique d'une pièce d'horlogerie selon l'invention ;
- La figure 2 est une vue en perspective d'un arbre horloger ;
- La figure 3 est une vue en perspective partielle d'un mécanisme d'échappement d'un mouvement horloger.

### DESCRIPTION DÉTAILLÉE D'AU MOINS UN MODE DE RÉALISATION DE L'INVENTION

Sur les différentes figures, les éléments identiques ou similaires portent les mêmes références, éventuellement additionnés d'un indice. La description de leur structure et de leur fonction n'est donc pas systématiquement reprise.

Dans tout ce qui suit, les orientations sont les orientations des figures. En particulier, les termes « supérieur », « inférieur », « gauche », « droit », « au-dessus », « en-dessous », « vers l'avant » et « vers l'arrière » s'entendent généralement par rapport au sens de représentation des figures.

Par « matériau amagnétique », on entend un matériau qui n'est pas ou peu influencé par le magnétisme. Un tel matériau est un matériau dont la susceptibilité magnétique est faible ou très faible (χm est négatif ou faiblement positif comme par exemple inférieur à 1 10⁻³ ou à 1 10⁻⁴). Un tel matériau peut ainsi être un matériau paramagnétique ou diamagnétique.

Par « à base de », on entend un matériau ou alliage constituant au moins 50 % en masse totale ou poids d'une pièce donnée.

Par « pièce d'horlogerie », on entend tous les types d'instruments de mesure ou de comptage du temps tels que les pendules, les pendulettes, les montres, etc...

Par « mouvement horloger », on entend tous les types de mécanisme capables de compter le temps et alimentés à base d'énergie mécanique (par exemple un barillet) ou électrique (par exemple une batterie).

Par « habillage », on entend tous les types de dispositifs capables de contenir, afficher, décorer et/ou commander un mouvement horloger comme, par exemple, tout ou partie d'une boîte, d'un bracelet ou d'un affichage.

Dans ce qui suit, sauf indication contraire, tous les pourcentages (%) indiqués sont des pourcentages en masse totale ou poids (en anglais « weight »).

La pièce horlogère a été développée pour s'appliquer au domaine horloger. Ainsi, la pièce horlogère peut former tout ou partie d'un habillage horloger 2 comme tout ou partie d'un cadran, d'un affichage tel qu'une aiguille ou un disque, d'une boîte, d'un bracelet ou d'un organe de commande tel qu'une couronne, une tige de remontoir ou un bouton-poussoir. La pièce horlogère peut également former tout ou partie d'un mouvement 3 comme tout ou partie d'un dispositif d'échappement tel qu'un mécanisme à ancre suisse 15, 16, 17, d'un résonateur tel qu'un mécanisme balancier - spiral, d'une source d'énergie tel qu'un barillet, un système de remontage automatique, d'un rouage tel qu'un mobile ou une roue dentée, d'un ressort, d'une vis, d'un pont ou d'une platine.

L'invention s'est révélée utile pour la fabrication d'arbres horlogers A, B, C comme un pivot 21, 22, 23, 24, une bonde de barillet ou une tige de remontoir, d'engrenages comme une roue dentée 18 ou un pignon 19 et diverses pièces utilisées en frottement telles qu'un sautoir, un cliquet, un tambour de barillet ou une lame ressort de barillet.

À cet effet, l'invention se rapporte à un procédé de fabrication d'une pièce horlogère comportant une première étape a destinée à former une pièce horlogère. Le matériau de la pièce horlogère peut comporter un réseau cristallin ou non, c'est-à-dire peut être au moins partiellement amorphe comme, par exemple, un alliage métallique amorphe, également appelé « verre métallique » (en anglais « bulk metallic glass » ou BMG »). La pièce horlogère est à base d'au moins un matériau métallique amagnétique. Afin de préparer la pièce horlogère pour l'étape b, l'étape a peut, selon une première variante, comporter une fabrication additive. Une telle fabrication pourrait, de manière non limitative, comprendre un processus de lithographie, comme par exemple une photolithographie, destiné à former un moule dans lequel un dépôt, comme par exemple une croissance galvanique, une croissance en phase gazeuse, une croissance chimique, une injection ou un coulage, est ensuite effectué pour former la pièce horlogère. Il est également envisageable de former la pièce horlogère par une impression en trois dimensions.

Selon une deuxième variante, l'étape a peut comporter une première sous-étape de fabrication du matériau sous forme d'ébauche, comme par exemple une barre, une plaque ou un lopin, à partir d'un coulage dans un moule, suivie d'une deuxième sous-étape de mise en forme de l'ébauche, comme par exemple un décolletage tel qu'un tournage, un fraisage, un usinage mécanique ou laser, et/ou une mise en forme par matage tel qu'un laminage ou un estampage.

Quelles que soient les étapes mises en œuvre lors de l'étape a, la pièce horlogère est préférentiellement finie, c'est-à-dire possède sensiblement ses dimensions et géométries finales avant le début de l'étape b (il peut être envisagé, suivant la pièce horlogère à fabriquer, l'ajout d'une étape d optionnelle comme expliqué ci-dessous). De plus, le matériau métallique amagnétique préféré peut être un matériau à base de cuivre (pur ou en alliage), à base de nickel (pur ou en alliage), à base d'or (pur ou en alliage), à base d'alliage argent-palladium (alliage binaire pur ou comportant plus d'élément(s) d'alliage), à base de cobalt (pur ou en alliage), à base de chrome(pur ou en alliage), à base de tungstène(pur ou en alliage), à base de fer amagnétique (pur ou en alliage), à base de titane (pur ou en alliage) ou à base d'acier inoxydable du type austénitique comme du type 316L. Bien entendu, d'autres types de matériaux et notamment d'autres matériaux métalliques amagnétiques peuvent être envisagés sans sortir du cadre de l'invention.

Le procédé comporte ensuite une étape b destinée à réaliser au moins une implantation ionique d'atomes d'au moins deux types différents d'éléments chimiques pour former des composés chimiques de ces deux différents éléments chimiques dans le réseau cristallin du matériau de la pièce horlogère afin d'améliorer les propriétés tribologiques comme, notamment, la résistance à l'usure et/ou les caractéristiques mécaniques de la pièce horlogère sans dégrader la résistance à la corrosion du matériau de la pièce horlogère. Enfin, l'étape b peut avantageusement être utilisée en outre pour modifier la couleur de la pièce horlogère.

Il est ainsi souhaité d'intégrer un premier élément chimique, comme par exemple du carbone, de l'azote, de l'oxygène ou du bore, et au moins un deuxième élément chimique, comme par exemple du silicium ou du bore, afin de former des composés chimiques, comme par exemple du carbure de silicium, du carbure de bore, du borure de silicium, du nitrure de carbone, du nitrure de silicium ou du nitrure de bore. Par conséquent, dans l'exemple expliqué ci-dessus, si le premier élément chimique sélectionné est du bore, le deuxième élément chimique différent du premier ne peut donc être que du silicium pour former un borure de silicium.

Avantageusement selon l'invention, il peut ainsi être obtenu, par exemple, des borures et/ou des carbures et/ou des nitrures ou, plus généralement des composites métal - céramiques associés à des éléments comme le bore, l'azote et le carbone, formant une modification du réseau cristallin du matériau de la pièce horlogère, c'est-à-dire une interruption de la périodicité du cristal pour un matériau cristallin de la pièce horlogère ou un changement surfacique et/ou volumique pour un matériau amorphe de la pièce horlogère. Bien entendu, en cas de matériau semi-cristallin, c'est-à-dire comportant des parties cristallines et amorphes mélangées, ces effets peuvent être combinés.

Ainsi, l'étape b peut comporter une sous-étape d'implantation ionique pour plusieurs types différents d'éléments chimiques en même temps ce qui permet de limiter le nombre de sous-étapes.

Alternativement, l'étape b peut comporter plusieurs sous-étapes d'implantation ionique, chaque implantation ionique étant mise en œuvre pour un unique type d'élément chimique en même temps ce qui permet de faire appel à différentes techniques d'implantation ionique comme, par exemple, l'implantation par faisceau d'ions (en anglais « beamline ion implantation ») et l'implantation par immersion plasma (en anglais « plasma immersion ion implantation » ou « PIII ») permettant notamment d'obtenir un plus grand nombre de composés chimiques.

Selon une autre alternative, l'étape b peut être réalisée à chaud ou, après l'étape b, une étape c de traitement thermique est réalisée afin de faciliter la formation des composés chimiques. Typiquement, l'étape b est préférentiellement réalisée à une température comprise entre 300 °C et 500 °C ou l'étape c est préférentiellement réalisée à une température comprise entre 300 °C et 500 °C pendant une durée comprise entre 1 heure et 24 heures. L'apport de chaleur est privilégié pour améliorer la combinaison entre eux des éléments chimiques intégrés par implantation ionique et pour implanter ces derniers plus profondément dans la pièce horlogère.

La température est préférentiellement comprise entre 400 °C et 480 °C et, encore plus préférentiellement, comprise entre 400 °C et 450 °C, c'est-à-dire par exemple est égale à 400 °C, 405 °C, 410 °C, 415 °C, 420 °C, 425 °C, 430 °C, 435 °C, 440 °C, 445 °C, 450 °C ou peut évoluer entre deux de ces températures. La durée de l'étape c est préférentiellement comprise entre 2 heures et 12 heures et, encore plus préférentiellement, entre 3 heures et 7 heures, c'est-à-dire par exemple est égale à 3 heures, 3,5 heures, 4 heures, 4,5 heures, 5 heures, 5,5 heures, 6 heures, 6,5 heures, 7 heures ou une durée intermédiaire entre deux de ces valeurs. La température et, éventuellement, la durée de l'étape c sont dépendantes du type de matériau de la pièce horlogère et/ou des éléments chimiques intégrés.

Enfin, le procédé selon l'invention peut comporter, avant l'étape b et/ou après l'étape b, une étape d de finition destinée à modifier l'état de surface de la pièce horlogère. Typiquement, l'étape d peut comporter une sous-étape de polissage et/ou une sous-étape de roulage et/ou une sous-étape de décoration. À titre d'exemple, une sous-étape de polissage après l'étape b peut être rendue nécessaire si la surface extérieure de la pièce horlogère, avant l'implantation ionique des éléments chimiques, est très rugueuse, une étape de roulage peut améliorer la dureté et la précision géométrique de la pièce horlogère et une étape de décoration peut améliorer l'esthétique de la pièce horlogère.

Une étude comparative reproduisant les conditions de frottement d'un pivot horloger a été menée pour mesurer les variations de coefficient de frottement et de résistance à l'usure pour trois types d'échantillons. Un premier type d'échantillons comporte des pièces formées à base d'acier austénitique de type 316L qui ont subi un polissage. Un deuxième type d'échantillons comporte des pièces formées à base d'acier austénitique de type 316L qui ont subi un polissage, une implantation ionique d'atomes d'un élément chimique unique puis un traitement thermique à 425 °C pendant au moins 3 heures. Enfin, un troisième type d'échantillons comporte, avantageusement selon l'invention, des pièces formées à base d'acier austénitique de type 316L (étape a) qui ont subi un polissage (étape d), au moins une implantation ionique de composés chimiques formés par plusieurs éléments chimiques combinés (étape b) puis un traitement thermique à 425 °C pendant au moins 3 heures (étape c).

Bien que la dureté de la surface externe soit effectivement augmentée sur le deuxième type d'échantillons, il a été remarqué qu'une intégration interstitielle d'atomes d'azote donnait satisfaction pendant une durée assez limitée et qu'une dégradation de la surface de contact intervenait à court terme.

Dans le cas du troisième type d'échantillons selon l'invention, il a été observé une résistance à l'usure et un coefficient de frottement de la pièce horlogère améliorés de manière durable, c'est-à-dire aussi bien à court terme qu'à long terme, notamment pour des composés chimiques du type carbure de silicium par rapport à ceux du premier type d'échantillons. En outre, la résistance à la corrosion de l'acier austénitique du type 316L n'est pas dégradée.

Avantageusement selon l'invention, le procédé n'intègre pas des éléments chimiques uniques de manière interstitielle ou substitutionnelle comme dans les documents EP 2 757 423 et EP 3 273 303 mais des composés chimiques qui sont beaucoup plus stables dans le réseau cristallin du matériau de la pièce horlogère, c'est-à-dire qui notamment sont plus difficiles à se combiner à des éléments chimiques déjà présents dans le matériau de la pièce horlogère comme du chrome et qui ont une possibilité de migration très limitée dans ou entre chaque maille du réseau cristallin.

L'invention n'est pas limitée aux modes de réalisation et variantes présentés et d'autres modes de réalisation et variantes apparaîtront clairement à l'homme du métier. Ainsi, les modes de réalisation et variantes sont combinables entre eux sans sortir du cadre de l'invention.

## Revendications

1. Procédé de fabrication d'une pièce horlogère comportant les étapes suivantes :
a. Former une pièce horlogère (A, B, C) à base d'un matériau métallique amagnétique ;
b. Réaliser au moins une implantation ionique d'atomes d'au moins deux types différents d'éléments chimiques, un premier élément chimique étant choisi parmi du carbone, de l'azote, de l'oxygène et du bore et un deuxième élément chimique, différent du premier élément chimique, étant choisi parmi le silicium et le bore, pour former des composés chimiques de ces deux différents éléments chimiques dans le réseau cristallin du matériau de la pièce horlogère afin d'améliorer les propriétés tribologiques comme, notamment, la résistance à l'usure et/ou les caractéristiques mécaniques de la pièce horlogère (A, B, C) sans dégrader la résistance à la corrosion du matériau de la pièce horlogère.

2. Procédé selon la revendication précédente, dans lequel le matériau métallique amagnétique est un matériau à base de cuivre, à base de nickel, à base d'or, à base d'alliage argent-palladium, à base de cobalt, à base de chrome, à base de tungstène, à base de fer amagnétique, à base de titane ou à base d'acier inoxydable du type austénitique.

3. Procédé selon l'une des revendications précédentes, dans lequel l'étape b comporte une sous-étape d'implantation ionique pour plusieurs types différents d'éléments chimiques en même temps.

4. Procédé selon l'une des revendications 1 à 2, dans lequel l'étape b comporte plusieurs sous-étapes d'implantation ionique, chaque implantation ionique étant mise en œuvre pour un unique type d'élément chimique en même temps.

5. Procédé selon l'une des revendications précédentes, dans lequel l'étape b est réalisée à chaud afin de faciliter la formation des composés chimiques.

6. Procédé selon la revendication précédente, dans lequel l'étape b est réalisée à une température comprise entre 300 °C et 500 °C.

7. Procédé selon l'une des revendications 1 à 4, comportant, après l'étape b, une étape c de traitement thermique afin de faciliter la formation des composés chimiques dans la pièce horlogère.

8. Procédé selon la revendication précédente, dans lequel l'étape c est réalisée à une température comprise entre 300 C et 500 °C pendant une durée comprise entre 1 heure et 24 heures.

9. Procédé selon l'une des revendications précédentes, comportant, avant l'étape b et/ou après l'étape b, une étape d de finition destinée à modifier l'état de surface de la pièce horlogère (A, B, C).

## Patentansprüche

1. Verfahren zur Herstellung einer Uhr, das die folgenden Schritte umfasst:
a. Formen eines Zeitmessers (A, B, C) aus einem nichtmagnetischen metallischen Material;
b. Durchführung von mindestens einer Ionenimplantation von Atomen aus mindestens zwei verschiedenen Arten von chemischen Elementen, wobei ein erstes chemisches Element aus Kohlenstoff, Stickstoff, Sauerstoff und Bor ausgewählt wird und ein zweites chemisches Element, das sich vom ersten chemischen Element unterscheidet, aus Silizium und Bor ausgewählt wird, um chemische Verbindungen dieser zwei verschiedenen chemischen Elemente im Kristallgitter des Materials der Uhr zu bilden, um die tribologischen Eigenschaften wie insbesondere die Verschleißfestigkeit und/oder die mechanischen Eigenschaften der Uhr (A, B, C) zu verbessern, ohne die Korrosionsbeständigkeit des Materials der Uhr zu verschlechtern.

2. Verfahren nach dem vorhergehenden Anspruch, wobei das nichtmagnetische metallische Material ein Material auf Kupferbasis, auf Nickelbasis, auf Goldbasis, auf Basis einer Silber-Palladium-Legierung, auf Kobaltbasis, auf Chrombasis, auf Wolframbasis, auf Basis von nichtmagnetischem Eisen, auf Titanbasis oder auf Basis von rostfreiem Stahl des austenitischen Typs ist.

3. Verfahren nach einem der vorhergehenden Ansprüche, wobei Schritt b einen Unterschritt der Ionenimplantation für mehrere verschiedene Arten von chemischen Elementen zur gleichen Zeit umfasst.

4. Verfahren nach einem der Ansprüche 1 bis 2, wobei Schritt b mehrere Unterschritte der Ionenimplantation umfasst, wobei jede Ionenimplantation für einen einzigen Typ eines chemischen Elements zur gleichen Zeit durchgeführt wird.

5. Verfahren nach einem der vorhergehenden Ansprüche, wobei Schritt b bei Hitze durchgeführt wird, um die Bildung der chemischen Verbindungen zu erleichtern.

6. Verfahren nach dem vorhergehenden Anspruch, wobei Schritt b bei einer Temperatur zwischen 300 °C und 500 °C durchgeführt wird.

7. Verfahren nach einem der Ansprüche 1 bis 4, das nach Schritt b einen Schritt c einer Wärmebehandlung umfasst, um die Bildung der chemischen Verbindungen in der Uhr zu erleichtern.

8. Verfahren nach dem vorhergehenden Anspruch, wobei Schritt c bei einer Temperatur zwischen 300 C und 500 °C für eine Dauer zwischen 1 Stunde und 24 Stunden durchgeführt wird.

9. Verfahren nach einem der vorhergehenden Ansprüche, das vor Schritt b und/oder nach Schritt b einen Endbearbeitungsschritt d umfasst, der dazu bestimmt ist, den Oberflächenzustand der Uhr (A, B, C) zu verändern.

## Claims

1. Method for manufacturing a timepiece comprising the following steps:
a. Forming a timepiece (A, B, C) based on a non-magnetic metallic material;
b. Making at least one ion implantation of atoms of at least two different types of chemical elements, a first chemical element being selected from carbon, nitrogen, oxygen and boron and a second chemical element, different from the first chemical element, being selected from silicon and boron, to form chemical compounds of these two different chemical elements in the crystalline network of the material of the timepiece to improve the tribological properties such as, in particular, the wear resistance and/or the mechanical characteristics of the timepiece (A, B, C) without impairing the corrosion resistance of the material of the timepiece.

2. Method according to the preceding claim, wherein the non-magnetic metallic material is a material based on copper, based on nickel, based on gold, based on a silver-palladium alloy, based on cobalt, based on chromium, based on tungsten, based on non-magnetic iron, based on titanium or based on austenitic type stainless steel.

3. Method according to one of the preceding claims, wherein step b comprises a sub-step of ion implantation for several different types of chemical element at the same time.

4. Method according to claim 1 or 2, wherein step b comprises several sub-steps of ion implantation, each ion implantation being implemented for a single type of chemical element at the same time.

5. Method according to one of the preceding claims, wherein step b is carried out hot to facilitate the formation of the chemical compounds.

6. Method according to the preceding claim, wherein step B is carried out at a temperature of between 300 °C and 500 °C.

7. Method according to one of claims 1 to 4, comprising, after step b, a step c of heat treatment to facilitate the formation of the chemical compounds in the timepiece.

8. Method according to the preceding claim, wherein step c is carried out at a temperature of between 300 °C and 500 °C for a duration of between 1 hour and 24 hours.

9. Method according to one of the preceding claims, comprising, before step b and/or after step b, a finishing step intended to modify the surface condition of the timepiece (A, B, C).
